**Europäisches Patentamt**

**European Patent Office**

**Office européen des brevets**

(19)

(11) **EP 1 473 848 A1**

(12) **EUROPEAN PATENT APPLICATION**
published in accordance with Art. 158(3) EPC

(43) Date of publication:
03.11.2004 Bulletin 2004/45

(51) Int Cl.7: **H04B 3/06**, H03H 21/00

(21) Application number: 03741291.3

(86) International application number:
**PCT/JP2003/008694**

(22) Date of filing: 09.07.2003

(87) International publication number:
**WO 2004/038949 (06.05.2004 Gazette 2004/19)**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(30) Priority: 24.10.2002 JP 2002309976

(71) Applicant: **MATSUSHITA ELECTRIC INDUSTRIAL
CO., LTD.**
**Kadoma-shi, Osaka 571-8501 (JP)**

(72) Inventor: **YAMANAKA, Ryutaro**
**Yokohama-shi, Kanagawa 233-0001 (JP)**

(74) Representative: **Grünecker, Kinkeldey,
Stockmair & Schwanhäusser Anwaltssozietät
Maximilianstrasse 58
80538 München (DE)**

(54) **PROCESSING DEVICE AND PROCESSING METHOD**

(57)    A calculation processing apparatus and a calculation processing method intended to suppress the operating speed of an LSI to a low level and realize size reduction, weight reduction and cost reduction of a portable terminal. Addition sections (120a-1 to 4) obtain channel estimation coefficients after updating based on a channel estimation coefficient before updating, multiplication result of a multiplier (110a), GND and a counter value of a 2-bit counter (130) or selection signal (600). The 2-bit counter (130) generates 2-bit numerical values in a predetermined clock number, outputs the respective bits to addition sections (120a-2, 3) and outputs a 2-bit counter value to a storage section (140). The storage section (140) outputs the channel estimation coefficient before updating to the addition sections (120a-1 to 4) based on the counter value of the 2-bit counter (130) and selection signal (600) and stores a channel estimation coefficient after updating in a predetermined storage area based on the counter value of the 2-bit counter (130).

FIG.4

**Description**

Technical Field

The present invention relates to a calculation processing apparatus and a calculation processing met hod.

Background Art

There is a conventional technology of applying equalization processing to a received signal in the mobile communication field for a reception apparatus to approximate a signal distorted due to influences of multi-paths, fading in the air or thermal noise in the reception apparatus to its originally transmitted signal.

In the equalization processing, an adaptive equalizer according to a maximum likelihood sequence estimation method using a Viterbi algorithm may be used (e.g., see the Unexamined Japanese Patent Publication No. HEI 7-95107). The equalizer described in the Unexamined Japanese Patent Publication No. HEI 7-95107 is constructed in such a way as to generate an estimated received signal at an estimated received signal section made up of a transversal filter, calculate an estimation error between the estimated received signal generated and the actually received signal, use the estimation error as a branch metric of the Viterbi algorithm and select a path with the smallest estimation error.

A filter coefficient of the transversal filter of this equalizer is determined by applying channel estimation processing using known signals (training sequence) sandwiched between neighboring pieces of data before the equalization processing is carried out. This filter coefficient is called a "channel estimation coefficient."

However, in a mobile communication where a propagation environment varies from moment to moment, for data which is temporally farther from a training sequence, the equalization performance deteriorates in the processing using the first determined channel estimation coefficient, and therefore it is necessary to adaptively update the channel estimation coefficient. In an environment in which a communication terminal apparatus moves at a high speed in particular, the propagation environment changes drastically, and so its performance deterioration is notable.

To update a channel estimation coefficient, an LMS (Least Means Square) algorithm with a relatively small amount of calculation may be used. The LMS algorithm uses an estimation error obtained by the maximum likelihood sequence estimation method as a correction value and updates the channel estimation coefficient state by state. The equalization processing which updates channel estimation coefficients using such an LMS algorithm is generally implemented through software processing using a processor such as a CPU (Central Processing Unit) and DSP (Digital Signal Processor) (e.g., see the Unexamined Japanese Patent Publication No.2000-36779).

However, carrying out the equalization processing by executing a Viterbi algorithm while operating the LMS algorithm state by state results in an enormous amount of calculation. Moreover, speedily carrying out an enormous amount of calculation requires the operating speed of the processor to be enhanced. Increasing the operating speed of the processor increases the circuit scale of the LSI used for the processor and increases power consumption, with the result that it is difficult to realize size reduction, weight reduction and cost reduction of a communication terminal apparatus such as a portable terminal.

This problem will be explained more specifically below.

In a mobile communication, there is a demand for keeping the life of a battery of a portable terminal for a long time. At the same time, there is also a demand for size reduction, weight reduction and cost reduction of the portable terminal. To meet all these demands simultaneously, it is necessary to reduce the circuit scale of the LSI and thereby reduce the number of transistors used, reduce the area of the chip and reduce the unit price of the chip.

Power consumption of an LSI generally increases in proportion to its operating speed. Furthermore, enhancing the LSI's operating speed requires the sizes of transistors to be increased and the operating voltage to be applied to the LSI to be increased. Thus, to carry out an enormous amount of calculation for operating the LMS algorithm state by state using the aforementioned processor, it is necessary to increase the chip size and power consumption of LSI. Therefore, there is a problem that it is not possible to keep the life of the battery of the portable terminal for a long time or achieve size reduction, weight reduction and cost reduction of the portable terminal.

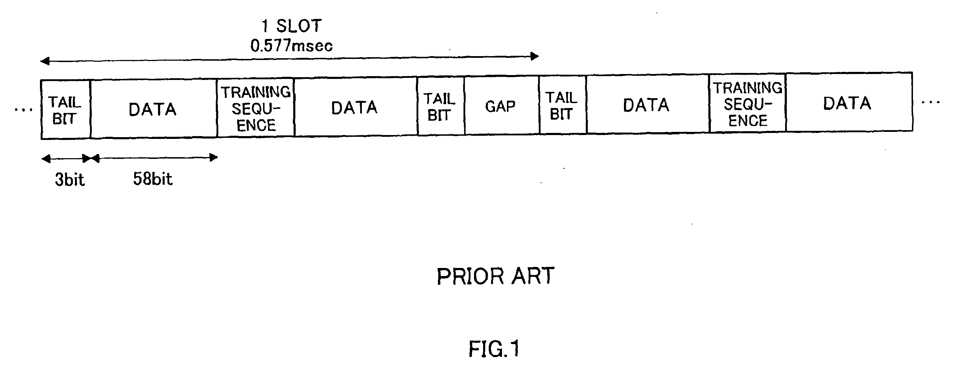

For example, in a TDMA communication having a slot structure as shown in FIG. 1, when slots are received consecutively (multi-slot reception), real-time processing is impossible unless equalization processing of a received slot is completed by the time the next slot is received and stored. Therefore, in the example in FIG. 1, equalization processing on two sets of 58-bit data and 3-bit tail bits, a total of 122 bits, must be completed within one-slot time of 0.577 msec (millisecond).

Conventional software processing requires approximately 50000 instructions for processing of the LMS algorithm and expected value generation of the received signal alone, and therefore completing this processing within 0.577 msec requires the processor to have an operating speed of a minimum of approximately 90 MHz (mega hertz).

Furthermore, other processing that should be carried out within the same slot time includes channel estimation processing and maximum likelihood sequence estimation processing, etc., and when all these are taken into consideration, the required operating speed increases further, requiring an LSI that operates at an operating speed of approximately 200 MHz or higher.

When an LSI operating at 200 MHz is mounted on a portable terminal, it is no longer possible to keep a long life of the battery as described above or achieve size reduction, weight reduction or cost reduction, either.

Disclosure of Invention

It is an object of the present invention to suppress the operating speed of an LSI to a low level and at the same time realize size reduction, weight reduction and cost reduction of a portable terminal.

It is a subject of the present invention to process an LMS algorithm by hardware, carry out a plurality of calculation processes simultaneously and improve the calculation speed.

According to an embodiment of the present invention, a calculation processing apparatus comprises a counter that generates a counter value in a predetermined cycle, a storage section that stores a plurality of calculation coefficients in a storage area corresponding to a counter value of the counter and an updating section that updates a calculation coefficient corresponding to the counter value of the counter out of a plurality of the stored calculation coefficients based on the counter value.

According to another embodiment of the present invention, a calculation processing method comprises a step of generating a counter value in a predetermined cycle, a step of updating the calculation coefficient corresponding to the counter value generated out of a plurality of calculation coefficients based on the counter value and a step of storing the updated calculation coefficient.

Brief Description of Drawings

FIG. 1 illustrates an example of a slot structure in a TDMA communication;
FIG.2 is a block diagram showing a configuration of an equalizer according to an embodiment of the present invention;
FIG.3 illustrates state transition according to an embodiment of the present invention;
FIG.4 is a block diagram showing a configuration of a channel estimation coefficient updating section according to Embodiment 1 of the present invention;
FIG.5 illustrates a configuration of an addition section according to Embodiment 1;
FIG.6 illustrates a configuration of a storage section according to Embodiment 1;
FIG.7 illustrates an output operation of a storage section according to Embodiment 1;
FIG.8 illustrates an input operation of the storage section according to Embodiment 1;
FIG.9 is a block diagram showing a configuration of a channel estimation coefficient updating section according to Embodiment 2 of the present invention;
FIG. 10 illustrates a configuration of an addition section according to Embodiment 2;
FIG.11 illustrates an operation of the addition section according to Embodiment 2;
FIG.12 illustrates a configuration of a storage section according to Embodiment 2;
FIG.13 illustrates an output operation of the storage section according to Embodiment 2; and
FIG. 14 illustrates an input operation of the storage section according to Embodiment 2.

Best Mode for Carrying out the Invention

With reference now to the attached drawings, embodiments of the present invention will be explained in detail below.

(Embodiment 1)

First, an overview of an LMS algorithm according to Embodiment 1 of the present invention will be explained. In this embodiment, a standard LMS algorithm shown in (Expression 1) below is used.

$$W[t+1]=W[t]+\alpha \times e[t] \times U[t] \qquad \text{(Expression 1)}$$

where, W[t] is a channel estimation coefficient of the state of a transition destination at time t, $\alpha$ is a constant, e [t] and U[t] denote an estimation error and an estimated transmission signal sequence respectively when transition takes place from one state to another at time t. Furthermore, there are independent channel estimation coefficients W[t] correspondingto (thenumber of taps)x(the number of states).

The LMS algorithm shown in (Expression 1) above calculates an error (that is, estimation error e[t]) between an expected value of a received signal value resulting from a maximum likelihood sequence estimation at time t, which is an expected value assuming that transition takes place from one state to another and an actually received signal value. Then, this estimation error e[t] is multiplied by an estimated transmission signal sequence U[t] which is estimated as the actually transmitted signal during transition. Furthermore, the multiplication result multiplied by the constant $\alpha$ and the channel estimation coefficient W[t] used for estimation at time t are added up to obtain a channel estimation coefficient W[t+1] at next time (t+1).

Here, each bit of the estimated transmission signal sequence U[t] in (Expression 1) can take a value "0" or "1", but a tap whose U[t] is "0" is multiplied by (+1) and a tap whose U[t] is "1" is multiplied by (-1).

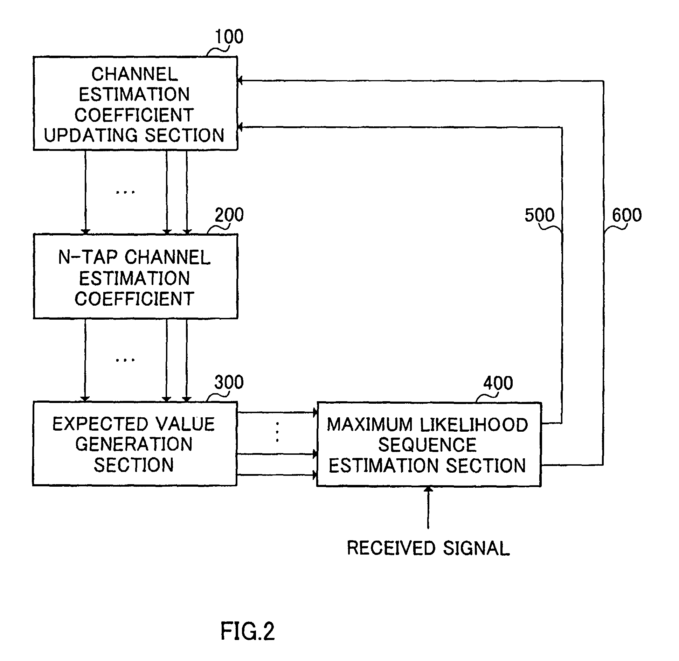

FIG.2 is a block diagram showing a configuration of an N-tap (N: integer) equalizer according to this embodiment. In the same figure, using an N-tap channel estimation coefficient 200, an expected value generation section 300 generates an expected value for the received signal. Using the expected value generated and the actual received signal, a maximum likelihood sequence estimation section 400 carries out a maximum likelihood sequence estimation based on a Viterbi algorithm. Then, in a maximum likelihood sequence estimation, an error signal 500 indicating an error between an expected value assuming that transition takes place from one state to another and the actual received signal value (that is, estimation error) and a selection signal 600 indicating "0" or "1" (i.e., the least significant bit in an estimated transmission signal sequence) selected as an actually transmitted signal as a result of the maximum likelihood sequence estimation is output to a channel estimation coefficient updating section 100. Then, the channel estimation coefficient updating section 100 updates the N-tap channel estimation coefficient 200 by carrying out an LMS algorithm calculation using the error signal 500 and selection signal 600.

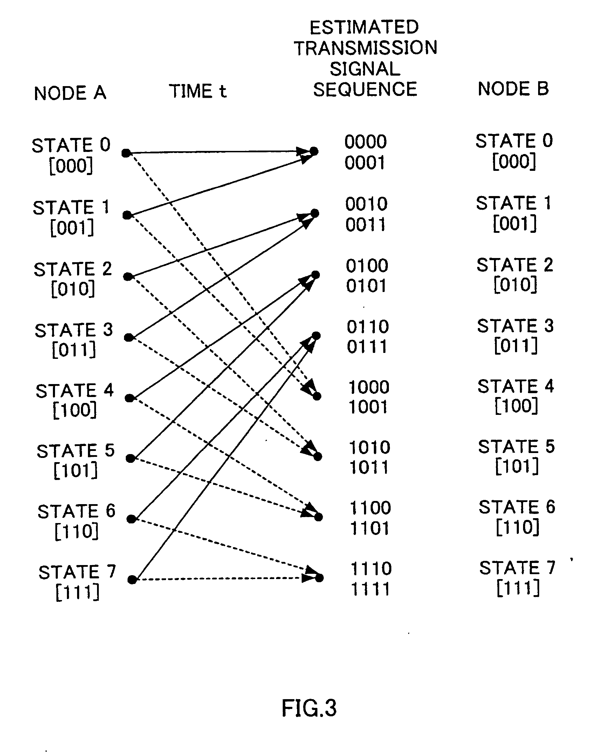

Here, with reference to a state transition diagram shown in FIG. 3, an overview of an operation of the equalizer shown in FIG.2 will be explained.

In the following explanations, the number of taps of the equalizer is assumed to be 4, but the present invention is not limited to this.

As shown in FIG.3, at time t at which transition takes place from node A which is the transition source to node B which is the transition destination, transition takes place from either state 0 or state 1 of the node A to state 0 and state 4 of the node B, for example. The expected value generation section 300 and maximum likelihood sequence estimation section 400 in FIG.2 estimate from which state of the node A transition takes place to these states of the node B. More specifically, the expected value generation section 300 uses "0000" as the estimated transmission signal sequence when transition is assumed to have taken place from state 0 to state 0 and "0001" as the estimated transmission signal sequence when transition is assumed to have taken place from state 1 to state 0 to generate expected values. Expected values are likewise generated for transition involving other states, too. Then, the maximum likelihood sequence estimation section 400 uses a received signal and expected value to carry out adaptive equalization of the received signal according to the Viterbi algorithm.

Then, "0" is output when state 0 is selected as the transition source and "1" is output when state 1 is selected as the selection signal 600 in FIG.2. At the same time, an error between the received signal and an expected value corresponding to the selectedpath of transition is output as the error signal 500 in FIG.2. Using these error signal 500 and selection signal 600, the channel estimation coefficient updating section 100 updates the N(here 4)-tap channel estimation coefficient 200.

The above described processing is likewise carried out on transition paths of other states. Here, the error signal 500 corresponds to e[t] of the aforementioned (Expression 1) and the estimated transmission signal sequence corresponding to the selected transition path corresponds to U[t] of (Expression 1). Furthermore, the channel estimation coefficient which belongs to the state of the selected transition source corresponds to W[t] in (Expression 1) and the channel estimation coefficient which belongs to the state of the corresponding node B corresponds to W[t+1] of (Expression 1).

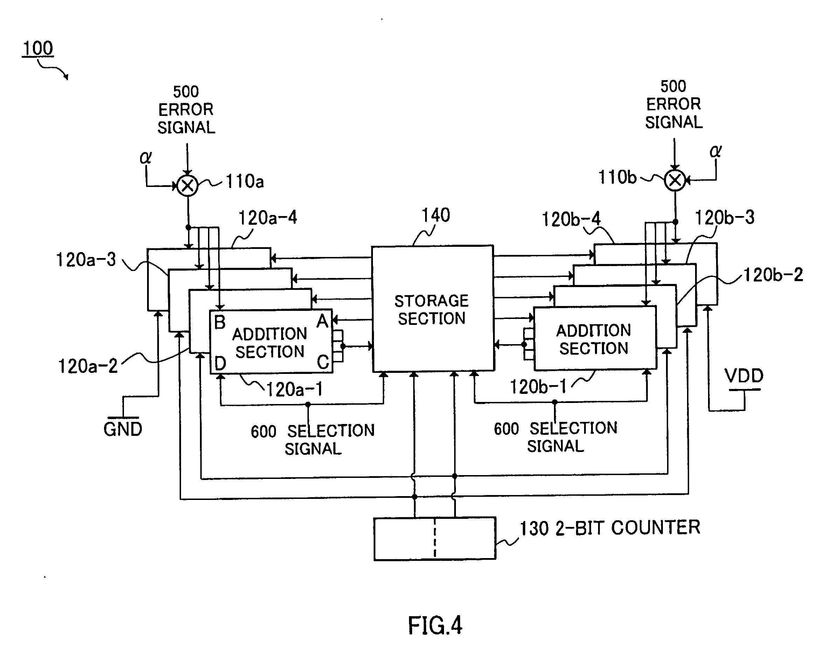

FIG.4 is a block diagram showing a configuration of the channel estimation coefficient updating section 100 according to this embodiment.

The channel estimation coefficient updating section 100 according to this embodiment is provided with a multiplier 110a, a multiplier 110b, addition sections 120a-1 to 4, addition sections 120b-1 to 4, a 2-bit counter 130 and a storage section 140. The line consisting of the multiplier 110a and addition sections 120a-1 to 4 and the line consisting of the multiplier 110b and addition sections 120b-1 to 4 operate in parallel, and in a maximum likelihood sequence estimation by the maximum likelihood sequence estimation section 400, the line of the multiplier 110a and addition sections 120a-1 to 4 carries out processing for the path whose transition destination is state 0 to 3 of the node B, while the line of the multiplier 110b and addition sections 120b-1 to 4 carries out processing for the path whose transition destination is state 4 to 7 of the node B.

The multiplier 110a (110b) multiplies the error signal 500 output from the maximum likelihood sequence estimation section 400 by a constant $\alpha$. The multiplication result is input to the addition sections 120a-1 to 4 (120b-1 to 4). Here, as described above, the error signal 500 is a signal which varies depending on the transition source of the state in a maximum likelihood sequence estimation, the error signal 500 corresponding to state 0 to 3 of the node B shown in FIG.3 is multiplied by the constant $\alpha$ by the multiplier 110a and the error signal 500 corresponding to state 4 to 7 of the node B shown in FIG.3 is multiplied by the constant $\alpha$ by the multiplier 110b. Furthermore, the selection signal 600 in the following explanation corresponding to state 0 to 3 is likewise input to the line of the multiplier 110a and addition sections 120a-1 to 4 and the selection signal 600 corresponding to state 4 to 7 is input to the line of the multiplier 110b and addition sections 120b-1 to 4.

The addition sections 120a-1 to 4 (120b-1 to 4) obtain a channel estimation coefficient belonging to a state at the node B (hereinafter, this output will be referred to as "C") based on a channel estimation coefficient belonging to a state at the node A output from the storage section 140 (hereinafter this input will be referred to as "A"), multiplication result of the multiplier 110a (110b) (hereinafter this input will be referred to as "B") and GND (VDD), counter value of the 2-bit counter 130 or selection signal 600 (hereinafter this input will be referred to as "D"). Here, GND denotes "0" and VDD denotes "1".

The 2-bit counter 130 generates a 2-bit numerical value at a predetermined clock number, outputs each bit to the addition sections 120a-2, 3 (120b-2, 3) and outputs a 2-bit counter value to the storage section 140.

The storage section 140 outputs a channel estimation coefficient before updating belonging to each state from a predetermined storage area to the addition sections 120a-1 to 4 (120b-1 to 4) based on the counter value of the 2-bit counter 130 and selection signal 600 and stores a channel estimation coefficient after updating belonging to each state output from the addition sections 120a-1 to 4 (120b-1 to 4) in a predetermined storage area based on the counter value of the 2-bit counter 130.

Here, when focused on an estimated transmission signal sequence at the node B again with reference to FIG.3, all the most significant bits of the estimated transmission signal sequences of states 0 to 3 are "0", all the most significant bits of the estimated transmission signal sequences of states 4 to 7 are "1". Therefore, in FIG. 4, GND indicating "0" and VDD indicating "1" are input (input D) to the addition section 120a-4 and addition section 120b-4, respectively. That is, the addition section 120a-4 and addition section 120b-4 update channel estimation coefficients of the highest tap.

Furthermore, the medium 2 bits of the estimated transmission signal sequences of states 0 to 3 at the node B are counted up by 1 at a time from state 0 to state 3. This is the same for the medium 2 bits of the estimated transmission signal sequences of state 4 to 7 at the node B. Therefore, in FIG.4, values of the respective bits of the 2-bit counter 130 are input (input D) to the addition sections 120a-2, 3 and addition sections 120b-2, 3. That is, the addition sections 120a-2, 3 and addition sections 120b-2, 3 update channel estimation coefficients of the medium 2 taps.

Furthermore, the least significant bits of the estimated transmission signal sequence of state 0 to 3 at the node B are "0" or "1", that is, signals corresponding to the paths selected through maximum likelihood sequence estimation as the actually transmitted signals. Therefore, the selection signal 600 is input (input D) to the addition section 120a-1. This is the same for the least significant bits of the estimated transmission signal sequences of state 4 to 7 at the node B, and the selection signal 600 is input (input D) to the addition section 120b-1. That is, the addition section 120a-1 and addition section 120b-1 update the channel estimation coefficient of the lowest tap.

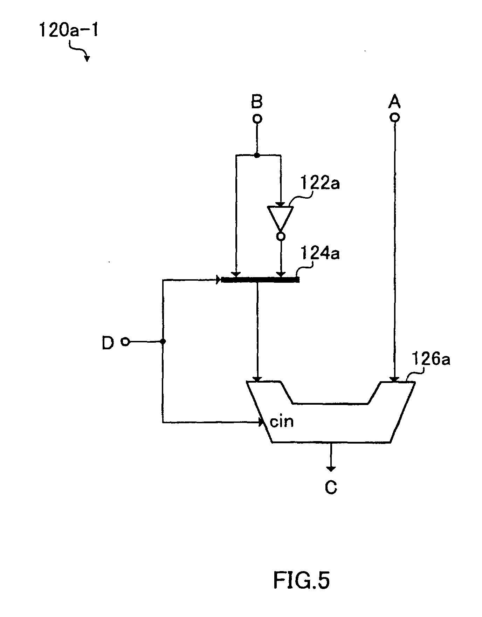

FIG. 5 shows a configuration of the addition section 120a-1. Suppose the addition sections 120a-2 to 4 and addition sections 120b-1 to 4 also have the same configuration. Furthermore, A, B, C and D in the same figure denote input A, input B, output C and input D in FIG.4.

In FIG. 5, the addition section 120a-1 is provided with an inverter 122a, a selector 124a and a full adder 126a.

The inverter 122a inverts the value of the input B. That is, the inverter 122a inverts the sign of the result of a multiplication of the error signal 500 by the constant $\alpha$.

The selector 124a selects and outputs the input B or the inverted value of the input B according to the value of the input D (selection signal 600 for the addition section 120a-1, and each bit of the 2-bit counter 130, GND or VDD for other addition sections). More specifically, the selector 124a selects and outputs the input B when the value of the input D is "0" and selects and outputs the output value of the inverter 122a when the value of the input D is "1".

The full adder 126a is constructed of a full adder of 1 bit or more and carries out an addition using the value of the input A (channel estimation coefficient of each tap before updating) and output value of the selector 124a and using the input D as a carry input (cin) of the least significant bit and obtains an output C.

The above described calculations are summarized as follows: When the input D is "0",

$$\text{Output C} = \text{input A} + \text{input B} \qquad \text{(Expression 2)}$$

is executed and when the input D is "1",

$$\text{Output C = input A + (-input B)} \qquad \text{(Expression 3)}$$

is executed.

Furthermore, when the input D indicating the value of each bit of the estimated transmission signal sequence is used, (Expression 2) and (Expression 3) can be merged into one (Expression 4) below:

$$\text{Output C = input A + input B} \times \text{input D} \qquad \text{(Expression 4)}$$

In (Expression 4) when the input D indicates signal "0", (+1) is multiplied and when the input D indicates signal "1", (-1) is multiplied.

When (Expression 4) is compared with (Expression 1) above, the input A corresponds to the channel estimation coefficient W[t] before updating and the input B corresponds to the result of multiplication of the estimation error e[t] by the constant $\alpha$ and the input D corresponds to the estimated transmission signal sequence U[t], and therefore it is evident that the update result W[t+1] of the channel estimation coefficient is obtained as the output C.

As shown above, 2's complement is calculated by a carry input to the inverter 122a and full adder 126a. In this way, it is possible to realize a multiplication on the estimated transmission signal sequence U[t] according to (Expression 1).

Furthermore, since only values are inverted between the input and output of the inverter 122a, the bit width of the output can be the same as the bit width of the input, which can reduce the complexity of the circuit. In other words, a numerical system of 1's complement is locally adopted to reduce the complexity of the circuit.

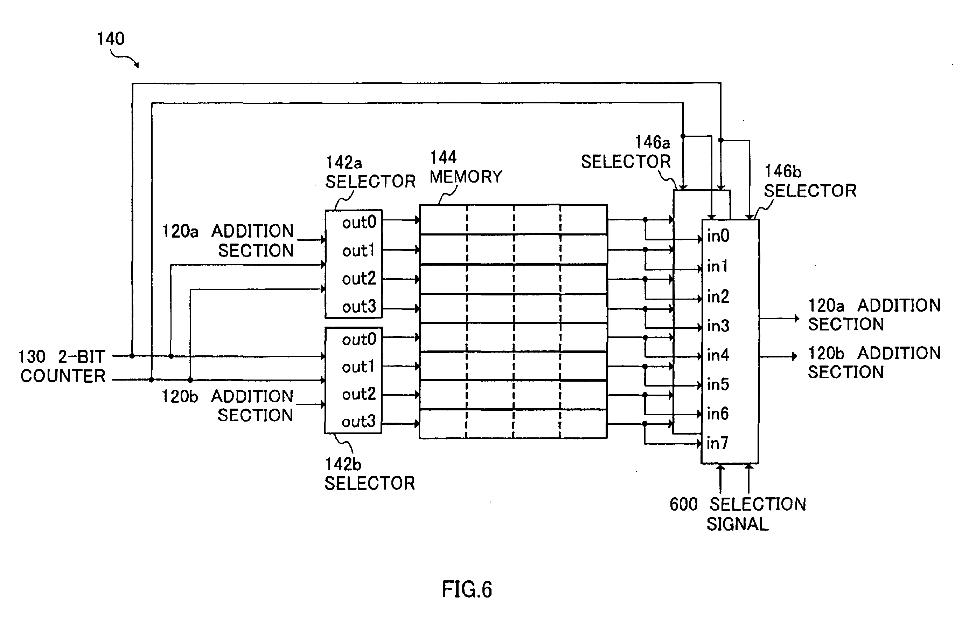

FIG.6 illustrates the configuration of the storage section 140.

In FIG.6, the storage section 140 is provided with a selector 142a, a selector 142b, a memory 144, a selector 146a and a selector 146b.

The selector 142a (142b) outputs channel estimation coefficients after updating output from the addition sections 120a-1 to 4 (120b-1 to 4) from output terminals out 0 to 3 according to the counter value of the 2-bit counter 130. These output terminals out 0 to 3 correspond to the respective states.

The memory 144 stores as many channel estimation coefficients as 4 taps x 8 states in the corresponding storage areas. The storage areas corresponding to the respective taps of the respective states of the memory 144 are made up of storage areas for storing channel estimation coefficients before updating and storage areas for storing channel estimation coefficient after updating, and the storage area for storing the channel estimation coefficients after updating in execution of the LMS algorithm at time t becomes the storage area for storing channel estimation coefficients before updating in execution of the LMS algorithm at next time (t+1). Furthermore, the storage area for storing channel estimation coefficients before updating in execution of the LMS algorithm at time t is used as the storage area for storing channel estimation coefficients after updating in execution of the LMS algorithm at next time (t+1).

More specifically, the memory 144 can be implemented in such a configuration that storage areas for storing channel estimation coefficients before updating and storage areas for storing channel estimation coefficients after updating are provided independently of one another and areas are switched every time the time changes.

Or when channel estimation coefficients before updating are read from storage areas corresponding to, for example, state 0 and state 1 in execution of the LMS algorithm at time t, it is also possible to store the channel estimation coefficients after updating corresponding to state 0 and state 4 in these storage areas, carry out similar operations sequentially until the storage of the channel estimation coefficients corresponding to state 3 and state 7 and perform access conversion in execution of the LMS algorithm at time (t+1) in such a way that the channel estimation coefficients corresponding to state 0 and state 1 are read from the storage areas in which the channel estimation coefficients are stored.

The selector 146a (146b) receives channel estimation coefficients before updating stored in the memory 144 from input terminals in 0 to 7 according to the counter value of the 2-bit counter 130 and selection signal 600 and outputs them to the addition section 120a (120b).

Then, the operation of the channel estimation coefficient updating section 100 configured as shown above will be explained.

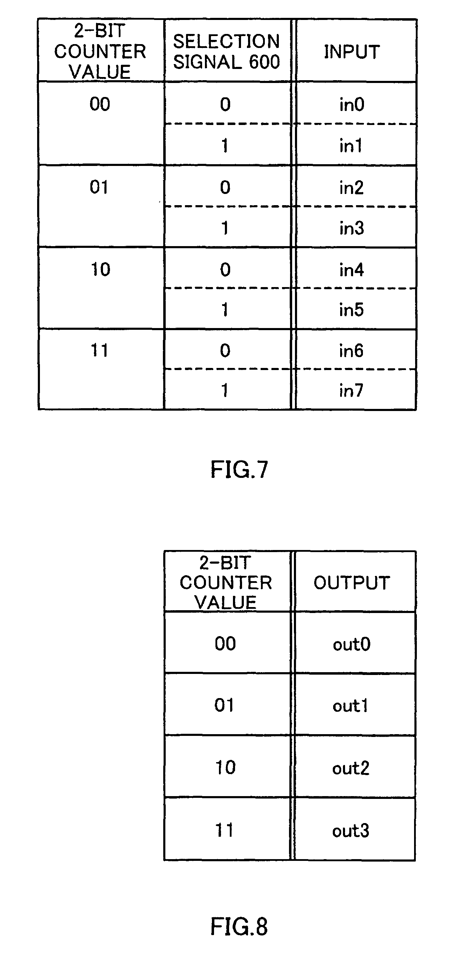

When the counter value of the 2-bit counter 130 is "00", the storage section 140 outputs a channel estimation coefficient corresponding to the counter value and selection signal 600. More specifically, the selector 146a (146b) selects an input terminal (here, in 0 or in 1) corresponding to the 2-bit counter value "00" and selection signal 600 according to the rule shown in FIG.7 and outputs the channel estimation coefficient stored in the memory 144 to the addition sections 120a-1 to 4 (120b-1 to 4). The channel estimation coefficient output here is one before updating (that is, one used for maximum likelihood sequence estimation at time t) and corresponds to the state of the node A in FIG.3.

Then, the addition sections 120a-1 to 4 (120b-1 to 4) carry out the aforementioned calculations and obtain updated values of channel estimation coefficients for the respective taps.

The updated values obtained are output to the storage section 140 and stored in the storage area corresponding to the counter value "00". More specifically, the selector 142a (142b) selects the output terminal (here, out 0) corresponding to the 2-bit counter value "00" according to the rule shown in FIG. 8 and stores the updated channel estimation coefficient in the memory 144. The channel estimation coefficient stored here is the one after updating (that is, the one used for maximum likelihood sequence estimation at time (t+1)) and corresponds to the state of the node B in FIG.3.

This means that the channel estimation coefficients corresponding to state 0 and state 4 at the node B in FIG. 3 have been updated.

Then, the 2-bit counter 130 is counted up and the counter value becomes "01". Then, as in the case where the counter value is "00", channel estimation coefficients are updated and the channel estimation coefficients corresponding to state 1 and state 5 at the node B in FIG.3 are updated.

Then, when the 2-bit counter 130 is counted up and the counter value becomes "10", the channel estimation coefficients corresponding to state 2 and state 6 at the node B in FIG.3 are updated, and when the counter value becomes "11", the channel estimation coefficients corresponding to state 3 and state 7 at the node B in FIG.3 are updated.

Thus, channel estimation coefficient updating processing on state 0 to 3 and channel estimation coefficient updating processing on state 4 to 7 at the node B in FIG. 3 are carried out in parallel, and therefore it is possible to complete updating of channel estimation coefficients based on an LMS algorithm corresponding to 8 states in four clocks.

On the other hand, the expected value generation section 300 requires 4 clocks for processing of generating expected values, and therefore the equalization processing in this embodiment requires a total of 8 clocks. In the case of the slot structure shown in FIG.1, it is necessary to complete the equalization processing on two sets of 58-bit data and 3-bit tail bits, a total of 122 bits within one-slot time of 0.577 msec (millisecond).

Therefore, processing of 122x8=976 clocks within 0.577 msec requires an operation at approximately 1.7 MHz (mega hertz), allowing the necessary operating speed to be reduced to approximately 1/50 of approximately 90 MHz which is the operating speed in the case of software processing.

Thus, according to this embodiment, channel estimation coefficients can be updated by hardware, and processing that can be performed in parallel is done in parallel, and therefore it is possible to update channel estimation coefficients belonging to all states by the time the counter value returns to its start point, suppress the operating speed of the LSI to a low level and at the same time achieve size reduction, weight reduction and cost reduction of the portable terminal.

This embodiment adopts the configuration shown in FIG.5 for the addition sections 120a-1 to 4 and addition sections 120b-1 to 4 for simplicity of explanations, but since the input D of the addition section 120a-4 and addition section 120b-4 is a fixed value (GND or VDD) as described above, no selection by the selector 124a is required. Therefore, the present invention can also be adapted so that the addition section 120a-4 always inputs the input A to the full adder 126a and inputs "0" (i.e., GND) as a carry input, while the addition section 120b-4 inputs a value obtained by inverting the input A by the inverter 122a to the full adder 126a and inputs "1" (i.e., VDD) as a carry input. This can further reduce the circuit scale.

(Embodiment 2)

A feature of Embodiment 2 of the present invention is that an LMS algorithm using a gradient filtering method is used to improve the accuracy with which channel estimation coefficients are updated.

First, an overview of the LMS algorithm will be explained in this embodiment, too. In this embodiment, an LMS algorithm using a gradient filtering method shown in (Expression 5) and (Expression 6) will be used.

$$A[t+1]=\omega\times A[t]+(1-\omega)\times e[t]\times U[t] \qquad \text{(Expression 5)}$$

$$W[t+1]=W[t]+\beta\times A[t+1] \qquad \text{(Expression 6)}$$

where, $W[t]$ is a channel estimation coefficient of a state of the transition destination at time t, $\beta$ is a constant, $e[t]$ and $U[t]$ are estimation error and estimated transmission signal sequence respectively when transition takes place from one state to another at time t, $A[t]$ is an error mean value at time t, $\omega$ is a filter coefficient ($0 \leq \omega \leq 1$). Furthermore, there are independent channel estimation coefficients $W[t]$ and error mean value $A[t]$ corresponding to (the number of taps) $\times$ (the number of states).

In (Expression 5) above, an error (that is, estimation error e[t]) between an expected value of a received signal value resulting from a maximum likelihood sequence estimation at time t, which is an expected value assuming that transition takes place from one state to another and an actually received signal value is calculated first. Then, this estimation error e[t] is multiplied by an estimated transmission signal sequence U[t] which is estimated as the actually transmitted signal during transition. Furthermore, the multiplication result multiplied by a constant (1- ω) and the error mean value A[t] multiplied by a constant ω used for estimation at time t are added up to obtain an error mean value A [t+1] at next time (t+1).

Furthermore, in (Expression 6) above, by adding a value obtained by multiplying the error mean value A[t+1] updated according to (Expression 5) by a constant value β to the channel estimation coefficient W[t] used for estimation at time t, a channel estimation coefficient W[t+1] at next time (t+1) is obtained.

Each bit of the estimated transmission signal sequence U[t] in (Expression 5) can take a value "0" or "1", but for a tap whose U[t] is "0", (+1) is multiplied and for a tap whose U[t] is "1", (-1) is multiplied.

Since the equalizer according to this embodiment is the same as that in Embodiment 1 (FIG.2), explanations thereof will be omitted. This embodiment will also describe the case where the number of taps of the equalizer is 4, but the present invention is not limited to this.

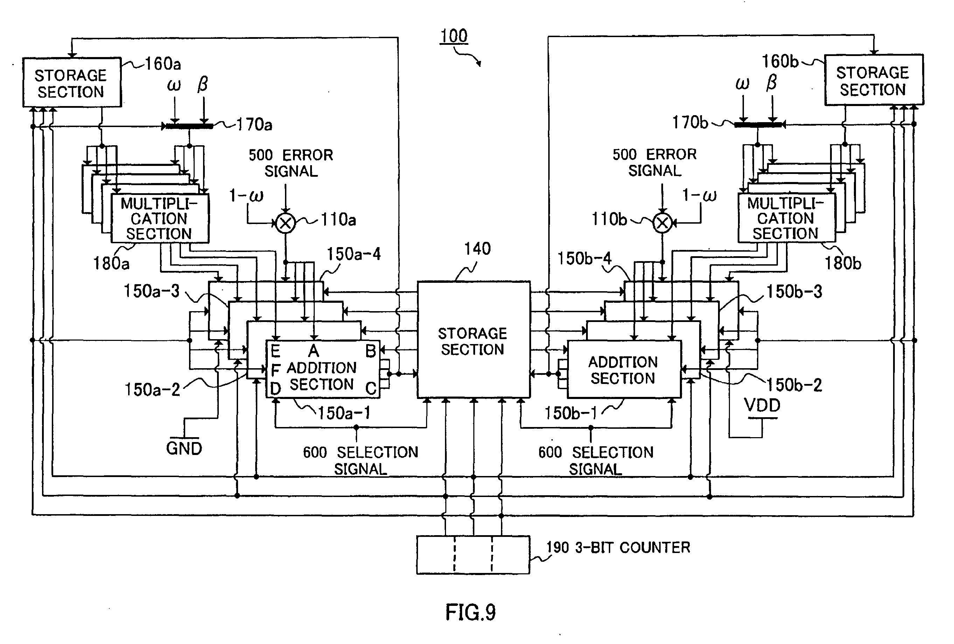

FIG.9 is a block diagram showing a configuration of a channel estimation coefficient updating section 100 according to this embodiment. In the same figure, the same components as those in FIG.4 are assigned the same reference numerals and explanations thereof will be omitted.

Thechannelestimationcoefficientupdatingsection 100 according to this embodiment is provided with a multiplier 110a, a multiplier 110b, a storage section 140, addition sections 150a-1 to 4, addition sections 150b-1 to 4, a storage section 160a, a storage section 160b, a selector 170a, a selector 170b, a multiplication section 180a, a multiplication section 180b and a 3-bit counter 190. The system made up of the multiplier 110a, addition sections 150a-1 to 4, storage section 160a, selector 170a, and multiplication section 180a and the system made up of the multiplier 110b, addition sections 150b-1 to 4, storage section 160b, selector 170b and multiplication section 180b operate in parallel, and the former carries out processing on the path corresponding to state 0 to 3 of the node B shown in FIG. 3 and the latter carries out processing on the path corresponding to state 4 to 7 of the node B shown in FIG.3.

The multiplier 110a (110b) multiplies the error signal 500 output from the maximum likelihood sequence estimation section 400 by a constant (1-ω). The multiplication result is input to the addition sections 150a-1 to 4 (150b-1 to 4).

The addition sections 150a-1 to 4 (150b-1 to 4) obtain an error mean value belonging to a state at the node B and a channel estimation coefficient (hereinafter, this output will be referred to as "C") based on the multiplication result (hereinafter, this input will be referred to as "A") of the multiplier 110a (110b), the channel estimation coefficient (hereinafter, this input will be referred to as "B") belonging to the state at the node A output from the storage section 140, the multiplication result (hereinafter, this input will be referred to as "E") of the multiplication section 180a (180b), the least significant bit (hereinafter, this input will be referred to as "F") of the 3-bit counter 190 and GND (VDD), the higher 2 bits of the counter value of the 3-bit counter 190 or selection signal 600 (hereinafter, this input will be referred to as "D"). Note that GND indicates "0" and VDD indicates "1".

The storage section 160a (160b) stores an error mean value belonging to each state in the storage area according to the higher two bits of the 3-bit counter 190 and outputs an error mean value from a predetermined storage area based on the counter value of the 3-bit counter 190.

The selector 170a (170b) outputs either a constant ω or a constant β according to the least significant bit of the 3-bit counter 190.

The multiplication section 180a (180b) multiplies the error mean value output from the storage section 160a (160b) by the constant ω or constant β output from the selector 170a (170b) and outputs the multiplication result to the addition sections 150a-1 to 4 (150b-1 to 4).

The 3-bit counter 190 generates a 3-bit numerical value at a predetermined clock number, outputs the higher two bits to the addition sections 150a-2, 3 (150b-2, 3) and outputs the least significant bit to the addition sections 150a-1 to 4 (150b-1 to 4) and the selector 170a (170b) and outputs the 3-bit counter value to the storage section 140 and storage section 160a (160b).

In this embodiment, 1-cycle processing is applied to calculations in aforementioned (Expression 5) and (Expression 6). That is, the calculation in (Expression 5) is carried out when the least significant bit of the 3-bit counter 190 is "0" and the calculation in (Expression 6) is carried out when the least significant bit of the 3-bit counter 190 is "1". Furthermore, the higher two bits of the 3-bit counter 190 correspond to the respective bits of the 2-bit counter 130 in Embodiment 1.

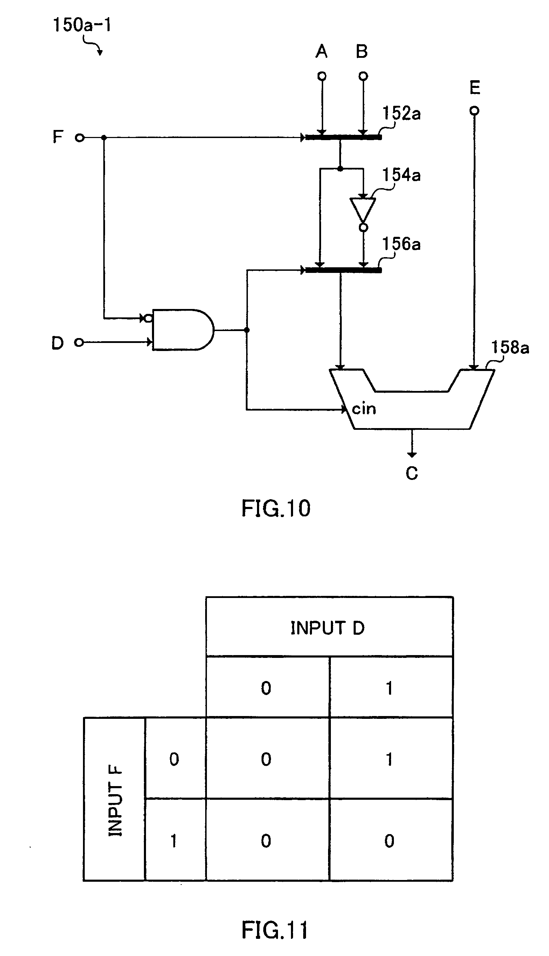

FIG. 10 shows a configuration of the addition section 150a-1. Suppose the addition sections 150a-2 to 4 and addition sections 150b-1 to 4 also have the same configuration. Furthermore, A, B, C, D, E and F in the same figure denote input A, input B, output C, input D, input E and input F in FIG.9.

In FIG.10, the addition section 150a-1 includes a selector 152a, an inverter 154a, a selector 156a and a full adder 158a.

The selector 152a outputs the value of input A (result of multiplication of the error signal 500 by constant $(1-\omega)$) or input B (channel estimation coefficient before updating output from the storage section 140) according to the value of input F (the least significant bit of the 3-bit counter 190). More specifically, the selector 152a selects and outputs input A if the value of input F is "0" and selects and outputs the value of input B if the value of input F is "1".

The inverter 154a inverts the output from the selector 152a. That is, the inverter 154a inverts the sign of the value of input A or input B.

The selector 156a selects and outputs the output value from the selector 152a or the value obtained by inverting this output value according to the value of a switch signal generated based on input D (selection signal 600 in the addition section 150a-1, but higher two bits of the 3-bit counter 190, GND, or VDD in other addition sections) and input F.

More specifically, the selector 156a selects and outputs the output value from the selector 152a when the switch signal is "0" and selects and outputs a value obtained by inverting this output value when the switch signal is "1" according to the value of the switch signal generated according to the table shown in FIG.11. Here, for the switch signal, the value of input D is output when input F is "0" and 0 is always output when input F is "1".

The full adder 158a is constructed of a full adder of 1 bit or more and carries out an addition using the above described switch signal as a carry input (cin) of the least significant bit, input E (multiplication result of multiplication section 180a) and the output value of the selector 156a and obtains output C.

Summarizing the above described calculations, if input F is "0",

$$\text{Output C} = \text{input E} + \text{input A} \times \text{input D} \qquad \text{(Expression 7)}$$

is executed and if input F is "1",

$$\text{Output C} = \text{input E} + \text{input B} \qquad \text{(Expression 8)}$$

is executed.

Here, in (Expression 7), when input D indicates signal "0", (+1) is multiplied and when input D indicates signal "1", (-1) is multiplied.

When (Expression 7) and (Expression 8) are compared with aforementioned (Expression 5) and (Expression 6), input B corresponds to the channel estimation coefficient W[t] before updating, input A corresponds to the result of multiplication of the estimation error e[t] by the constant $(1-\omega)$, input D corresponds to the estimated transmission signal sequence U[t], input E corresponds to the result of multiplication of the error mean value A[t] before updating by the constant $\omega$ or the result of multiplication of the error mean value A[t+1] after updating by the constant $\beta$ and output C corresponds to the error mean value A[t+1] after updating or channel estimation coefficient W[t+1] after updating.

Note that only values are inverted between the input and output of the inverter 154a, and therefore the output bit width can be the same as the bit width of the input, making it possible to reduce the complexity of the circuit. In other words, a numerical system of 1's complement is locally adopted to reduce the complexity of the circuit. Furthermore, since multiplications are realized by the inverter 154a, selector 156a and full adder 158a, it is possible to reduce the circuit scale.

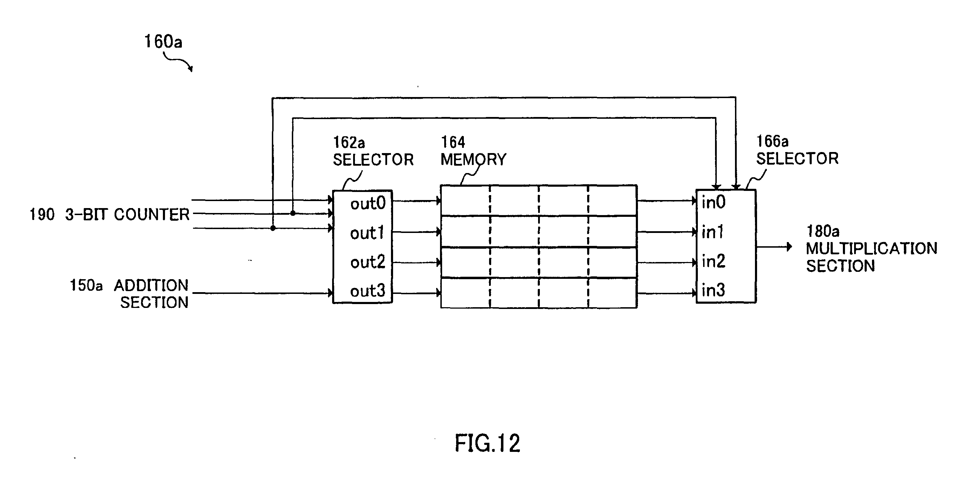

FIG.12 illustrates the configuration of the storage section 160a. The storage section 160b also has a similar configuration.

In FIG. 12, the storage section 160a is provided with a selector 162a, a memory 164a and a selector 166a.

The selector 162a outputs error mean values after updating output from the addition sections 150a-1 to 4 (150b-1 to 4) from output terminals out 0 to 3 according to the higher two bits of the 3-bit counter 190. These output terminals out 0 to 3 correspond to their respective states.

The memory 164a stores as many error mean values as 4 taps x4 states (for the storage section 160a, 4 states of states 0 to 3 in FIG.3) in their respective storage areas.

The selector 166a receives the error mean values after updating stored in the memory 164a from input terminals in 0 to 3 according to the counter value of the 3-bit counter 190 and outputs the error mean values to the multiplication section 180a.

Then, the operation of the channel estimation coefficient updating section 100 configured as shown above will be explained.

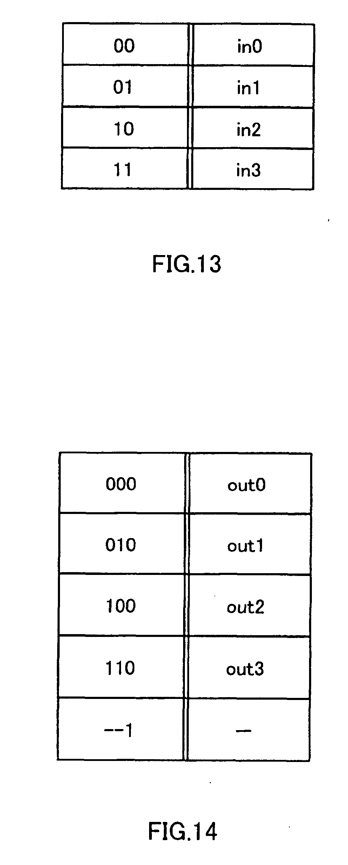

First, when the counter value of the 3-bit counter 190 is "000", the storage section 160a outputs the error mean values corresponding to the higher two bits (that is "00") of this counter value. More specifically, the selector 166a selects an input terminal (here, in 0) corresponding to the higher two bits "00" of the counter value according to the rule shown in FIG.13 and outputs the error mean values stored in the memory 164a to the multiplication section 180a.

At the same time, the least significant bit of the counter value (that is, "0") is input to the selector 170a, and a constant ω is thereby output from the selector 170a to the multiplication section 180a. Then, the error mean value is multiplied by the constant ω through the multiplication section 180a and the multiplication result is output to the addition sections 150a-1 to 4. This multiplication result corresponds to the above described input E.

Furthermore, the multiplier 110a multiplies the error signal 500 by a constant (1-ω) and outputs the multiplication result to the addition sections 150a-1 to 4. This multiplication result corresponds to the above described input A.

Then, using input E, input A, input F and input D, the addition sections 150a-1 to 4 carry out the above described calculations and obtain updated values of error mean values for the respective taps. These updated values are output to and stored in the storage section 160a as output C. More specifically, the selector 162a selects an input terminal (here, out 0) corresponding to the 3-bit counter value "000" according to the rule shown in FIG.14 and stores the updated error mean value in the memory 164a.

Here, as is evident from FIG. 14, only when the least significant bit of the 3-bit counter 190 is "0", the updated error mean values are output from the selector 162a and stored in the memory 164a.

Then, the 3-bit counter 190 is counted up and the counter value becomes "001".

When the counter is counted up, an error mean value corresponding to the higher two bits (that is "00") of this counter value is output from the storage section 160a to the multiplication section 180a according to the rule shown in FIG.13 again. Since the higher two bits of the 3-bit counter 190 do not change here either, the input terminal in 0 is selected, but the error mean value output from this input terminal is a value whose updating is already completed.

Furthermore, at the same time, the least significant bit (that is "1") of the counter value is input to the selector 170a, and a constant β is thereby output from the selector 170a to the multiplication section 180a. Then, the error mean value is multiplied by the constant β through the multiplication section 180a and the multiplication result is output to the addition sections 150a-1 to 4. This multiplication result corresponds to the above described input E.

Then, as in the case of Embodiment 1, the storage section 140 outputs the higher two bits of the3-bit counter 190 and the channel estimation coefficient corresponding to the selection signal 600. That is, the input terminal (here, in 0 or in 1) corresponding to the higher two bits "00" of the 3-bit counter 190 and the selection signal 600 is selected according to the rule shown in FIG.7 and the corresponding channel estimation coefficient is output to the addition sections 150a-1 to 4 (150b-1 to 4). This channel estimation coefficient corresponds to the above described input B.

Then, using input E, input B, input F and input D, the addition sections 150a-1 to 4 carry out the above described calculations and obtain updated values of the channel estimation coefficients for the respective taps. These updated values are output to and stored in the storage section 140 as output C.

In this way, the channel estimation coefficients corresponding to state 0 and state 4 at the node B in FIG.3 have been updated.

Then, the 3-bit counter 190 is counted up and the counter value becomes "010". Then, as in the case of the counter value "000", the error mean value is updated and when the counter value becomes "011", the channel estimation coefficient is updated.

Hereafter, channel estimation coefficients are likewise updated sequentially according to the counter value.

As shown above, the channel estimation coefficient updating processing on state 0 to 3 and channel estimation coefficient updating processing on state 4 to 7 at the node B in FIG.3 are carried out in parallel, and therefore it is possible to complete updating of error mean values and channel estimation coefficients based on the LMS algorithm of a gradient filtering method corresponding to 8 states in 8 clocks.

Furthermore, when four clocks necessary for the processing of generating expected value are added as in the case of Embodiment 1, equalization processing in this embodiment requires a total of 12 clocks. In the case of the slot structure shown in FIG. 1, it is necessary to complete equalization processing on two sets of 58-bit data and 3-bit tail bits, a total of 122 bits within one-slot time of 0.577 msec (millisecond).

Therefore, processing of 122x12=1464 clocks within 0.577 msec requires an operation at approximately 2.6 MHz (mega hertz), allowing the necessary operating speed to be reduced to approximately 1/35 of approximately 90 MHz which is the operating speed in the case of software processing.

Thus, according to this embodiment, channel estimation coefficients can be updated by hardware, processing that can be performed in parallel is done in parallel and circuits that can be shared are used in common, and therefore it is possible to update channel estimation coefficients belonging to all states by the time the counter value returns to its start point, suppress the operating speed of the LSI to a low level and at the same time achieve size reduction, weight reduction and cost reduction of the portable terminal.

As explained above, the present invention can suppress the operating speed of the LSI to a low level and at the same time achieve size reduction, weight reduction and cost reduction of the portable terminal.

This application is based on the Japanese Patent Application No.2002-309976 filed on October 24, 2002, entire content of which is expressly incorporated by reference herein.

Industrial Applicability

The present invention is applicable to a calculation processing apparatus and a calculation processing method. The present invention is particularly applicable to a calculation processing apparatus and a calculation processing method which updates channel estimation coefficients in a mobile station apparatus and base station apparatus carrying out adaptive equalization of a received signal using, for example, a Viterbi algorithm.

**Claims**

1.   A calculation processing apparatus comprising:

    a counter that generates a counter value in a predetermined cycle;
    a storage section that stores a plurality of calculation coefficients in a storage area corresponding to the counter value of said counter; and
    an updating section that updates the calculation coefficient corresponding to the counter value of said counter out of said stored plurality of calculation coefficients based on said counter value.

2.   The calculation processing apparatus according to claim 1, wherein said updating section updates channel estimation coefficients in adaptive equalization using a maximum likelihood sequence estimation.

3.   The calculation processing apparatus according to claim 2, wherein said updating section comprising:

    a first multiplier that multiplies an error signal indicating an error between a signal sequence obtained by estimation through a maximum likelihood sequence estimation and the actual signal by a constant value; and
    an addition section that updates said channel estimation coefficient by carrying out an addition using the result of themultiplication of said first multiplier, the respective bit values making up said signal sequence corresponding to said counter value and the channel estimation coefficient obtained through previous updating.

4.   The calculation processing apparatus according to claim 3, wherein said updating section further comprises :

    a storage section that stores a plurality of error mean values in a storage area corresponding to the counter value of said counter;
    a second multiplier that multiplies an error mean value corresponding to the counter value of said counter out of said plurality of stored error mean values by a constant value, and
    said addition section carries out updating processing by switching between updating processing on said error mean value using the multiplication result of said first multiplier, multiplication result of said second multiplier, respective bit values of said signal sequence corresponding to said counter value and the counter value of said counter, and updating processing on said channel estimation coefficient using the multiplication result of said second multiplier and said channel estimation coefficients obtained through previous updating.

5.   The calculation processing apparatus according to claim 1, wherein said updating section comprises an addition section provided according to the number of taps for processing at least three inputs, and
    said addition section adds up a second input and a third input based on a first input.

6.   The calculation processing apparatus according to claim 5, wherein said addition section comprising:

    an inverter that inverts said second input;
    a selector that selects and outputs either said second input or the output from said inverter based on said first input; and
    a full adder that adds said third input to the output from said selector using said first input as a carry input.

7.   The calculation processing apparatus according to claim 1, wherein said updating section comprises an addition section provided according to the number of taps for processing at least five inputs, and
    said addition section selects either a second input or a third input based on a first input and adds up the selected input and a fifth input based on said first input and a fourth input.

8.   The calculation processing apparatus according to claim 7, wherein said addition section comprises:

an inverter that inverts said selected input;

a selector that selects and outputs either said selected input or the output from said inverter based on said first input and said fourth input; and

a full adder that adds said fifth input to the output from said selector using the value generated from said first input and said fourth input as a carry input.

9. The calculation processing apparatus according to claim 1, wherein said storage section comprises a selector that selects a calculation coefficient to be output to said updating section according to said counter value.

10. The calculation processing apparatus according to claim 1, wherein said storage section comprises a selector that selects a storage area for storing said calculation coefficient according to said counter value.

11. Amobile station apparatus comprising the calculation processing apparatus according to claim 1.

12. A base station apparatus comprising the calculation processing apparatus according to claim 1.

13. A calculation processing method comprising:

a step of generating a counter value in a predetermined cycle;

a step of updating a calculation coefficient corresponding to the counter value generated out of a plurality of calculation coefficients based on said counter value; and

a step of storing the updated calculation coefficient.

**1 SLOT**
**0.577msec**

| ... | TAIL BIT | DATA | TRAINING SEQU-ENCE | DATA | TAIL BIT | GAP | TAIL BIT | DATA | TRAINING SEQU-ENCE | DATA | ... |

3bit     58bit

PRIOR ART

FIG.1

EP 1 473 848 A1

FIG.2

- 600
- 500
- 400 MAXIMUM LIKELIHOOD SEQUENCE ESTIMATION SECTION
- RECEIVED SIGNAL
- 100 CHANNEL ESTIMATION COEFFICIENT UPDATING SECTION
- 200 N-TAP CHANNEL ESTIMATION COEFFICIENT
- 300 EXPECTED VALUE GENERATION SECTION

FIG.3

FIG.4

120a-1

FIG.5

FIG.6

EP 1 473 848 A1

| 2-BIT COUNTER VALUE | SELECTION SIGNAL 600 | INPUT |
|---|---|---|
| 00 | 0 | in0 |
|  | 1 | in1 |
| 01 | 0 | in2 |
|  | 1 | in3 |
| 10 | 0 | in4 |
|  | 1 | in5 |
| 11 | 0 | in6 |
|  | 1 | in7 |

FIG.7

| 2-BIT COUNTER VALUE | OUTPUT |
|---|---|
| 00 | out0 |
| 01 | out1 |
| 10 | out2 |
| 11 | out3 |

FIG.8

FIG.9

150a-1

FIG.10

| | INPUT D | |
|---|---|---|
| | 0 | 1 |
| INPUT F | 0 | 0 | 1 |
| | 1 | 0 | 0 |

FIG.11

EP 1 473 848 A1

160a

162a SELECTOR  164 MEMORY  166a SELECTOR

190 3-BIT COUNTER

150a ADDITION SECTION

out0
out1
out2
out3

in0
in1
in2
in3

180a MULTIPLICATION SECTION

FIG.12

| | |
|---|---|
| 00 | in0 |
| 01 | in1 |
| 10 | in2 |
| 11 | in3 |

FIG.13

| | |
|---|---|
| 000 | out0 |
| 010 | out1 |
| 100 | out2 |
| 110 | out3 |
| --1 | — |

FIG.14

## INTERNATIONAL SEARCH REPORT

| International application No. |
|---|
| PCT/JP03/08694 |

| A. CLASSIFICATION OF SUBJECT MATTER |
|---|
| Int.Cl$^7$ H04B3/06, H03H21/00 |

According to International Patent Classification (IPC) or to both national classification and IPC

| B. FIELDS SEARCHED |
|---|
| Minimum documentation searched (classification system followed by classification symbols)<br>Int.Cl$^7$ H04B3/00, H04B7/00, H03H21/00 |
| Documentation searched other than minimum documentation to the extent that such documents are included in the fields searched |
| Electronic data base consulted during the international search (name of data base and, where practicable, search terms used) |

### C. DOCUMENTS CONSIDERED TO BE RELEVANT

| Category* | Citation of document, with indication, where appropriate, of the relevant passages | Relevant to claim No. |
|---|---|---|
| X<br>Y | Jiro YAMAUCHI, Shigekazu MORIGUCHI, Makoto ICHIMATSU, 'Denshi Keisanki no tame no Suchi Keisanho I', Suri Kagaku Series 1, Baifukan Co., Ltd., 20 January, 1965 (20.01.65), pages 160 to 163 | 1,13<br>2-12 |
| X<br>Y | Niklaus Wirth, translated by Kohei NOSHITA, Toshihiko TAKAMURA, Masato TAKEICHI, 'Keitoteki Programing-Nyumon', 2nd edition, Kindai Kagaku Sha, 01 May, 1978 (01.05.78), pages 67 to 77, 92 to 104 | 1,13<br>2-12 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 21 October, 2003 (21.10.03) | 04 November, 2003 (04.11.03) |

| Name and mailing address of the ISA/<br>Japanese Patent Office | Authorized officer |
|---|---|
| Facsimile No. | Telephone No. |

Form PCT/ISA/210 (second sheet) (July 1998)

**INTERNATIONAL SEARCH REPORT**

International application No.

PCT/JP03/08694

C (Continuation). DOCUMENTS CONSIDERED TO BE RELEVANT

| Category* | Citation of document, with indication, where appropriate, of the relevant passages | Relevant to claim No. |
|---|---|---|
| Y | E.Del Re, G.Castellini, L.Pierucci, F.Conti, "A within-burst adaptive MLSE receiver for mobile TDMA cellular systems", 1992 IEEE International Conference on Acoustics, Speech, and Signal Processing, ICASSP-92, Vol.4, (23-26 March, 1992), pages 493 to 496 | 2-12 |
| Y | Hiroshi KUBO, Keiji MURAKAMI, Tadashi FUJINO, "State goto Suitei o Mochiita Tekiogata Vitarbi Fukugoki no Tokusei", The Transactions of the Institute of Electro A, Vol.J77-A, No.12, (1994 December), pages 1650 to 1660 | 2-12 |
| Y | Guido Castellini, Fabrizio Conti, Enrico Del Re and Laura Pierucci, "A Continuously Adaptive MLSE Receiver for Mobile Communications: Algorithm and Performance", IEEE Transactions on Communications, Vol.45, No.1, (January, 1997), pages 80 to 89 | 2-12 |
| Y | JP 2002-252574 A (Matsushita Electric Industrial Co., Ltd.), 06 September, 2002 (06.09.02), Particularly, Fig. 1; Par. No. [0042] & US 2002/0118741 A1 | 5-8 |

Form PCT/ISA/210 (continuation of second sheet) (July 1998)

## INTERNATIONAL SEARCH REPORT

International application No.

PCT/JP03/08694

| Box I | Observations where certain claims were found unsearchable (Continuation of item 2 of first sheet) |
|---|---|

This international search report has not been established in respect of certain claims under Article 17(2)(a) for the following reasons:

1. ☐ Claims Nos.:

   because they relate to subject matter not required to be searched by this Authority, namely:

2. ☐ Claims Nos.:

   because they relate to parts of the international application that do not comply with the prescribed requirements to such an extent that no meaningful international search can be carried out, specifically:

3. ☐ Claims Nos.:

   because they are dependent claims and are not drafted in accordance with the second and third sentences of Rule 6.4(a).

| Box II | Observations where unity of invention is lacking (Continuation of item 3 of first sheet) |
|---|---|

This International Searching Authority found multiple inventions in this international application, as follows:

(See extra sheet)

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** ☐ The additional search fees were accompanied by the applicant's protest.

☒ No protest accompanied the payment of additional search fees.

Form PCT/ISA/210 (continuation of first sheet (1)) (July 1998)

**INTERNATIONAL SEARCH REPORT**

International application No.

PCT/JP03/08694

Continuation of Box No.II of continuation of first sheet(1)

1. Document to be referenced

Document 1: Jiro YAMAUCHI, Shigekazu MORIGUCHI, Shin ICHIMATSU, 'Denshi Keisanki no tameno Suuri Keisan'hou I', Suuri Kagaku Series 1, Baifukan Co., Ltd., 20 January 1965 (20.01.65), pages 160 to 163

2. Explanation

The technical feature common to claims 1-13 is a technical feature disclosed in claim 1 or 13.
However, the technical feature of claim 1 or 13 is a conventional one in numeric calculation in the computer and cannot be a special technical feature within the meaning of PCT Rule 13.2, second sentence. (If necessary, see, for example, the program for solution of a partial differentiation equation on pp. 160-163. The loop index M of the for loop basically operates identically as a counter . Since an ordinary computer is driven by a clock, the loop index generates a value by a predetermined cycle. Additionally, the arrangement U has MM storage areas according to the value of the loop index M and stores the calculation result updated according to the loop index value (see SINKO of the program list).
Furthermore, since there exits no other common feature which can be considered as a special technical feature within the meaning of PCT Rule 13.2, second sentence, no technical relationship within the meaning of PCT Rule 13 can be seen between claims 2, 5, 7, 9, 10, 11, 12 referring to claim 1.
Accordingly, claims 1-13 do not satisfy the requirement of unity of invention and are divided into the following groups of inventions.

    Group 1: claims 1-4, 13
    Group 2: claims 5, 6
    Group 3: claims 7, 8
    Group 4: claim 9
    Group 5: claim 10
    Group 6: claim 11
    Group 7: claim 12

Form PCT/ISA/210 (extra sheet) (July 1998)